# EUROPEAN PATENT APPLICATION

(11) **EP 2 555 596 A1**
(43) Date of publication of application: **06.02.2013**
(21) Application number: 11762676.2
(22) Date of filing: 24.03.2011
(51) Int. Cl.: H05B 33/22, H01L 51/50, H05B 33/12, H05B 33/26

(54) **LIGHT EMITTING DEVICE**

(30) Priority: 29.03.2010 JP 2010074566
(71) Applicant: Sumitomo Chemical Company Limited, Tokyo 104-8260 (JP)
(72) Inventor: KURIHARA Takashi, Tsukuba-shi Ibaraki 305-0045 (JP); AKATSU Mitsutoshi, Niihama-shi Ehime 792-0009 (JP); FUJISAWA Takuji, Niihama-shi Ehime 792-0025 (JP)
(74) Representative: Jackson, Martin Peter
(86) International application number: PCT/JP2011/057210
(87) International publication number: WO 2011/122445

(57) **Abstract**

The present invention provides a light emitting device 11 that includes a support substrate 13, partition walls 12 provided on the support substrate 13 and defining sections set on the support substrate 13, and a plurality of organic electroluminescent (EL) elements 14 provided on the sections defined by the partition walls 12. Each of the organic EL elements 14 is configured by laminating a first electrode 15, an organic EL layer, and a second electrode 18 in this order on the support substrate 13. At least part of the first electrode 15 is arranged apart from the partition walls 12 on the support substrate 13. The organic EL layer has an extension portion 20 extending from the first electrode 15 to the partition walls 12. A surface of a member in contact with a bottom surface of the extension portion 20 has a lyophilic property higher than that of a surface of each of the partition walls 12. Accordingly, a light emitting device 11 having a structure that makes it possible to fabricate organic EL elements 14 having excellent light-emitting properties by partition walls 12 having a simple structure.

## Description

### Technical Field

The present invention relates to a light emitting device.

### Background Art

As a display device, there are various types of devices having different configurations or principles. As one of them, a display device using organic electroluminescent (EL) elements as light sources for pixels has been being put to practical use.

This display device includes a plurality of organic EL elements arranged in an aligned manner on a support substrate. Generally on the support substrate, partition walls for defining predetermined sections are provided. The organic EL elements each are provided on the sections defined by the partition walls in an aligned manner.

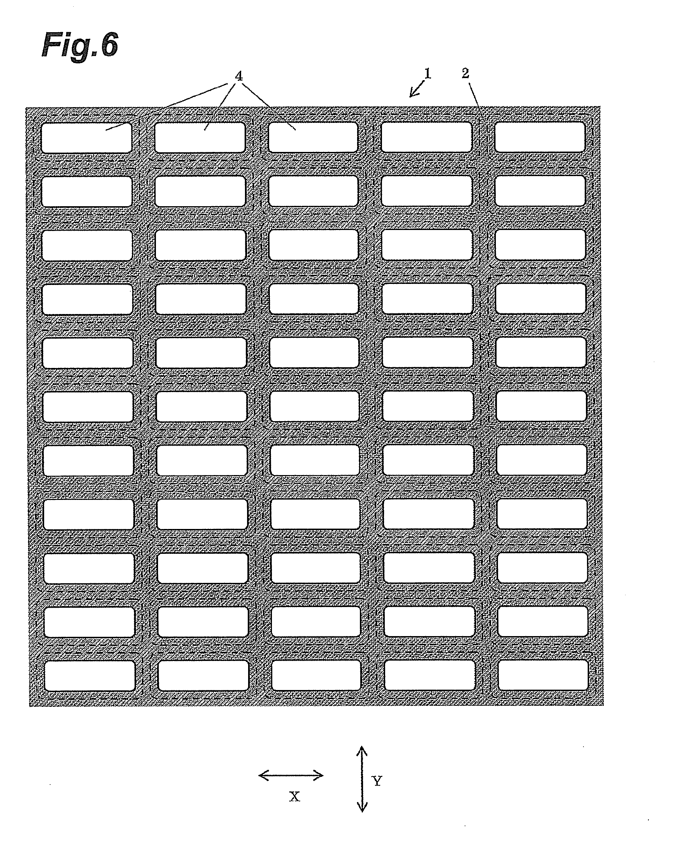

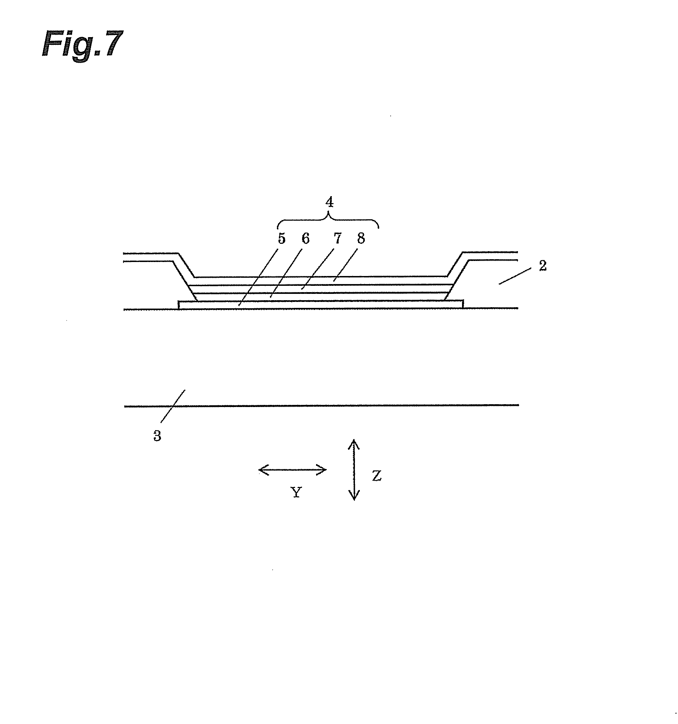

Fig. 6 is a plan view schematically illustrating a light emitting device 1 including a plurality of organic EL elements 4. Fig. 7 is a sectional view schematically illustrating in an enlarged manner part of the light emitting device 1 depicted in Fig. 6. In Fig. 6, locations in which partition walls 2 are provided are hatched. As depicted in Fig. 6, when the partition walls 2 in a grid pattern are provided on a support substrate 3, the organic EL elements 4 are provided in areas surrounded by the partition walls 2 and are arranged in a matrix pattern at predetermined intervals each in the row direction X and in the column direction Y.

Each of the organic EL elements 4 is fabricated by laminating a first electrode 5, organic EL layers 6 and 7, and a second electrode 8 in this order on the support substrate 3. Note that in Fig. 6, each location in which the first electrode 5 is provided is indicated by a dashed line surrounding it.

The organic EL layers 6 and 7 constituting part of the organic EL elements 4 can be formed by a coating method. More specifically, it is possible to form the organic EL layers 6 and 7 by supplying ink containing material to be the organic EL layers 6 and 7 into an area surrounded by the partition walls 2 and further solidifying them.

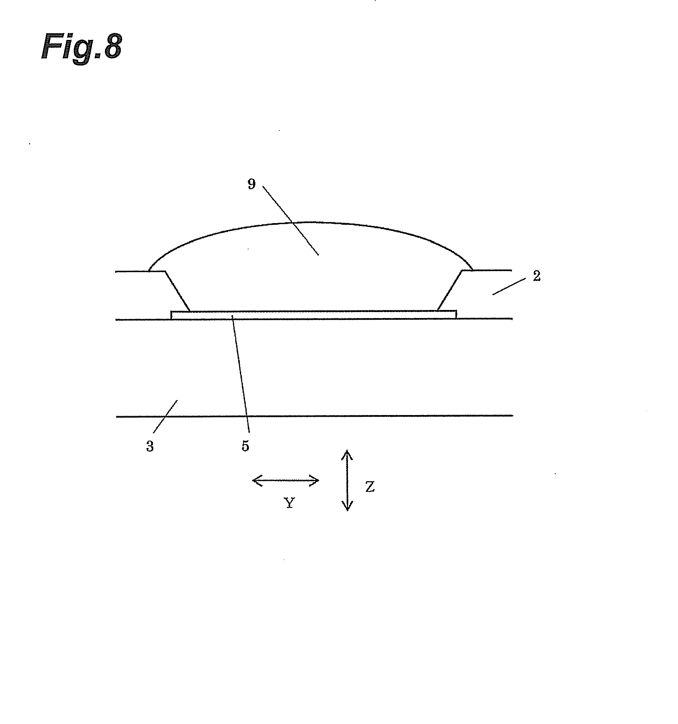

Fig. 8 is a diagram schematically illustrating a state immediately after supplying ink 9 containing material to be the organic EL layer 6 into the area surrounded by the partition walls 2. The solid concentration of the ink 9 is generally on the order of several percent at the highest. Accordingly, a large amount of ink 9 compared to volume of the organic EL layer 6 is supplied into the area surrounded by the partition walls 2.

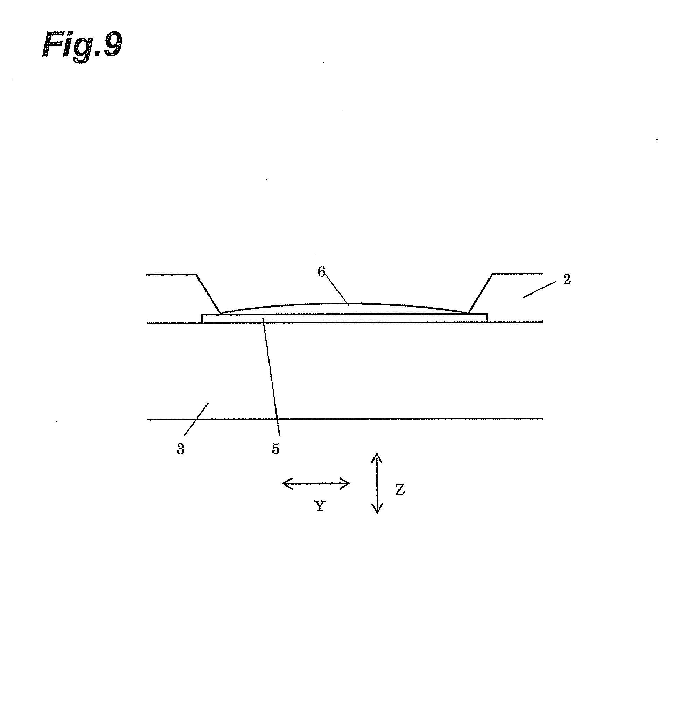

When using members exhibiting a lyophilic property as the partition walls, there are occasions when ink supplied into the area surrounded by the partition walls overflows down surfaces of the partition walls to outside. Accordingly, to retain the ink within the area surrounded by the partition walls, it is preferable to use members exhibiting a certain level of liquid-repellent property as the partition walls. On the other hand, when using partition walls exhibiting a liquid-repellent property, there are occasions when properties and condition of surfaces of the partition walls exert an influence on formability of the organic EL layers. For example, when using partition walls exhibiting a liquid-repellent property and supplying ink into an area surrounded by these partition walls, the ink dries while being repelled by surfaces of the partition walls and solidifies, and thus there are occasions when the film thickness of the organic EL layers in boundary areas between the organic EL layers and the partition walls becomes extremely small compared with the film thickness in the center portion. Such a state is schematically illustrated in Fig. 9. In this case, current flows in a concentrated manner through portions the film thickness of which is small when driving the organic EL elements, whereby light-emitting properties of the organic EL elements problematically deteriorate. Accordingly, to obtain organic EL layers in uniform film thickness, it is preferable to use members exhibiting a lyophilic property for the partition walls 2. In this manner, while partition walls exhibiting a certain level of liquid-repellent property are required in terms of retentivity of ink, partition walls exhibiting a certain level of lyophilic property are required in terms of formability of the organic EL layers.

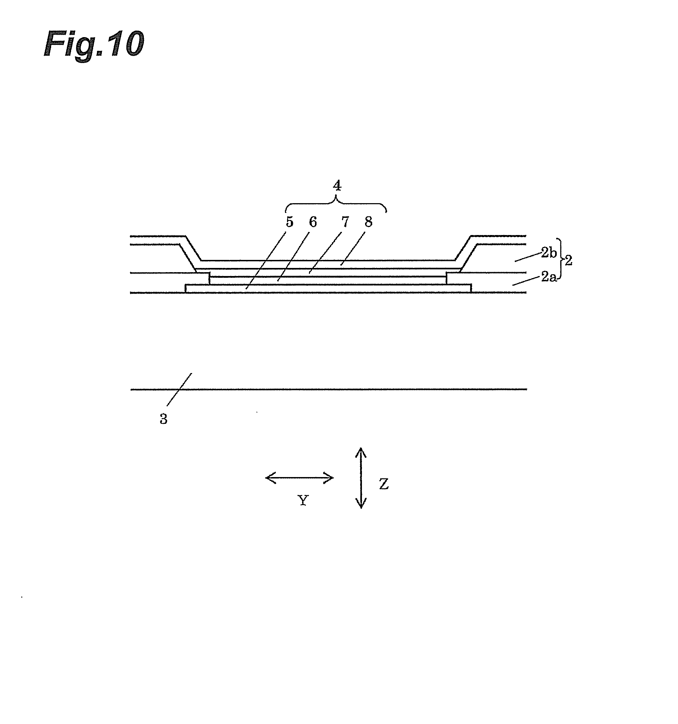

In a conventional technique, to satisfy conflicting requirements for the partition walls 2 at the same time, the partition walls 2 are used each of which is obtained by laminating a first partition wall member 2a and a second partition wall member 2b exhibiting different ink wetting properties from each other as depicted Fig. 10. More specifically, each of the partition walls 2 is configured with the first partition wall member 2a exhibiting a lyophilic property and the second partition wall member 2b exhibiting a liquid-repellent property being laminated (see Patent Literature 1, for example).

### Citation List

### Patent Literature

[Patent Literature 1] Japanese Patent Application Laid-Open Publication No. 2006-216253.

### Summary of Invention

### Technical Problem

When forming partition walls having a two-layer structure as in the conventional technique, the number of processes problematically increases compared to when forming partition walls having a one-layer structure.

Therefore, an object of the present invention is to provide a light emitting device having a structure that makes it possible to fabricate organic EL elements having excellent light-emitting properties by partition walls having a simple structure.

### Solution to Problem

The present invention relates to a light emitting device that includes a support substrate, partition walls provided on the support substrate and defining sections set on the support substrate, and a plurality of organic EL elements provided on the sections defined by the partition walls. Each of the organic EL elements is configured by laminating a first electrode, an organic EL layer, and a second electrode in this order on the support substrate. At least part of the first electrode is arranged apart from the partition walls on the support substrate. The organic EL layer has an extension portion extending from the first electrode to the partition walls. A surface of a member in contact with a bottom surface of the extension portion has a lyophilic property higher than that of a surface of each of the partition walls.

The present invention relates to the light emitting device, in which the partition walls are formed so that a surface of each of the partition walls facing the first electrode becomes more separate from the first electrode as a distance from the support substrate increases.

In addition, the present invention relates to the light emitting device, in which an insulating film is formed on a surface of the support substrate, and the first electrode, the partition walls, and the extension portion are arranged in contact with the insulating film.

In addition, the present invention relates to the light emitting device, in which the support substrate is made of a glass plate, and the extension portion is arranged in contact with the glass plate.

In addition, the present invention relates to the light emitting device, in which the first electrode has a shape extending in a predetermined longitudinal direction on the support substrate, and one end and the other end of the longitudinal direction of the first electrode are arranged apart from the partition walls.

### Advantageous Effects of Invention

With the light emitting device of the present invention, it becomes possible to fabricate organic EL elements having excellent light-emitting properties by partition walls having a simple structure.

### Brief Description of Drawings

[Fig. 1] Fig. 1 is a plan view schematically illustrating a light emitting device 11 according to an embodiment of the present invention.
[Fig. 2] Fig. 2 is a sectional view schematically illustrating the light emitting device 11 in an enlarged manner.
[Fig. 3] Fig. 3 is a plan view schematically illustrating a light emitting device 21 according to another embodiment of the present invention.
[Fig. 4] Fig. 4 is a sectional view schematically illustrating the light emitting device 11 in an enlarged manner when the light emitting device 11 is sectioned by a plane perpendicular to a row direction X.
[Fig. 5] Fig. 5 is a plan view schematically illustrating the light emitting device provided with a plurality of partition walls extending in the row direction X.
[Fig. 6] Fig. 6 is a plan view schematically illustrating a conventional light emitting device 1.
[Fig. 7] Fig. 7 is a sectional view schematically illustrating part of the light emitting device 1 depicted in Fig. 6 in an enlarged manner.
[Fig. 8] Fig. 8 is a diagram schematically illustrating a state immediately after supplying ink 9 containing material to be an organic EL layer 6 into an area surrounded by partition walls 2.
[Fig. 9] Fig. 9 is a diagram for explaining a film forming state of the organic EL layer 6 when using partition walls exhibiting a liquid-repellent property.
[Fig. 10] Fig. 10 is a sectional view schematically illustrating the conventional light emitting device 1.

### Description of Embodiments

A light emitting device of the present invention includes a support substrate, partition walls provided on the support substrate and defining sections set on the support substrate, and a plurality of organic EL elements provided on the sections defined by the partition walls, in which each of the organic EL elements is configured by laminating a first electrode, an organic EL layer, and a second electrode in this order on the support substrate, at least part of the first electrode is arranged apart from the partition walls on the support substrate, the organic EL layer has an extension portion extending from the first electrode to the partition walls, and a surface of a member in contact with a bottom surface of the extension portion has a lyophilic property higher than that of a surface of each of the partition walls.

Light emitting devices are used as a display device or an illuminating device, for example. Examples of the light emitting devices mainly include a device of an active matrix driving type and a device of a passive matrix driving type. The present invention can be applied to display devices of both types, but in the present embodiment, a light emitting device applied to the display device of the active matrix driving type will be described as one example. Note that in the present embodiment, a light emitting device including organic EL elements that function as light sources of pixels will be described, but the present invention can be applied to a light emitting device including organic EL elements that function as backlights.

### <Structure of Light Emitting Device>

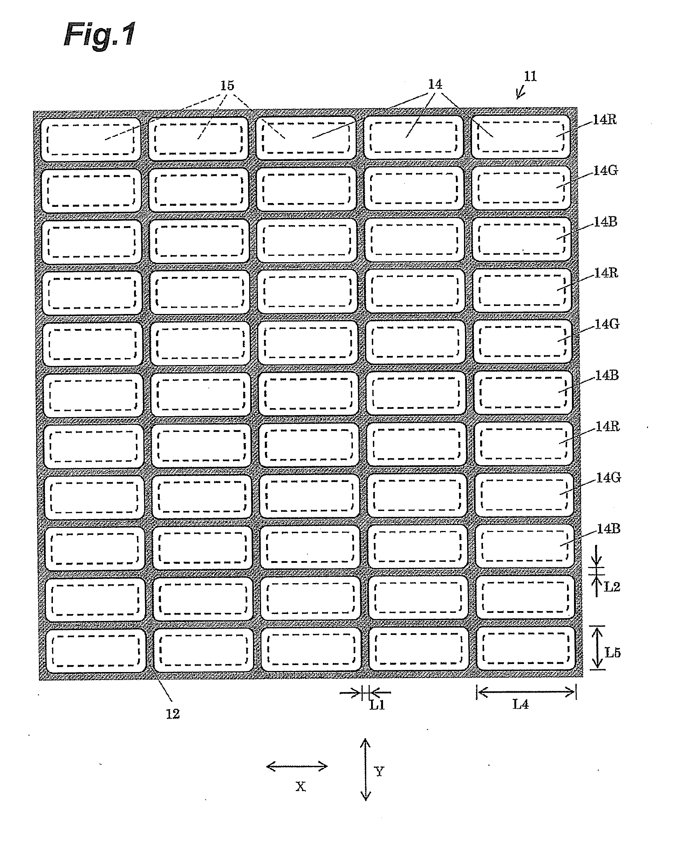

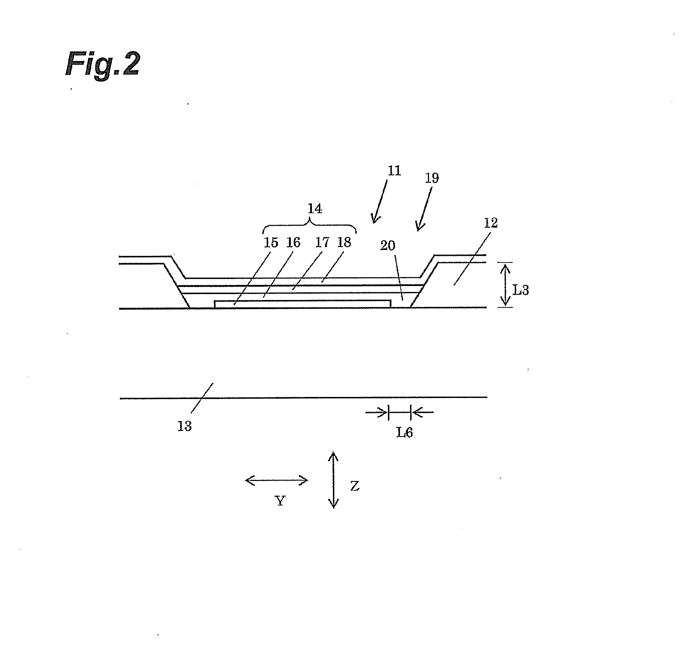

A structure of a light emitting device will now be described. Fig. 1 is a plan view schematically illustrating this light emitting device 11 of the present embodiment, and Fig. 2 is a sectional view schematically illustrating the light emitting device 11 in an enlarged manner. The light emitting device 11 is configured to mainly include a support substrate 13, partition walls 12 provided on the support substrate 13 and defining sections set on the support substrate 13, and a plurality of organic EL elements 14 provided on the sections defined by the partition walls 12.

The partition walls 12 are provided to define the sections set on the support substrate 13. The organic EL elements 14 are each arranged in an aligned manner on the sections defined by the partition walls 12. A shape of the partition walls 12 is designed based on a shape of the sections set on the support substrate 13. For example, when sections in a matrix pattern are set on the support substrate 13, as partition walls defining these sections in the matrix pattern, the partition walls 12 in a grid pattern are provided on the support substrate 13. Alternatively, when sections in a stripe pattern are set on the support substrate 13, as partition walls defining these sections in the stripe pattern, the partition walls 12 in a stripe pattern are provided on the support substrate 13. In the present embodiment, an embodiment in which the partition walls 12 in a grid pattern are provided on the support substrate 13 will be described. Note that in Figs. 1, 3, and 5, locations in which the partition walls are provided are hatched, and locations in which first electrodes are provided are indicated by dashed lines surrounding them.

The partition walls 12 in a grid pattern are configured with a plurality of strip-shaped electrically insulating members extending in a row direction X and a plurality of strip-shaped electrically insulating members extending in a column direction Y being formed in an integrated manner. In other word, the partition walls 12 have a shape in which many openings are formed in a matrix pattern on a thin film exhibiting an electrical insulating property. Note that in the present embodiment, the row direction X and the column direction Y represent directions perpendicular to each other, and also directions each perpendicular to a thickness direction Z of the support substrate 13.

When viewed from one side of the thickness direction of the support substrate 13 (hereinafter, also referred to as "in a planar view"), the openings of the partition walls 12 are formed in positions overlapping the organic EL elements 14. In other word, the organic EL elements 14 are provided in the openings of the partition walls 12. Each of the openings of the partition walls 12 is formed so as to substantially fit to a first electrode 15 described later in a planar view, and formed in a substantially rectangular shape, an oval shape, a substantially circular shape, and a substantially elliptical shape, for example. The partition walls 12 in a grid pattern are formed on areas excluding the first electrode 15 in a planar view, and are arranged at a predetermined spacing from the first electrode 15. More specifically, the partition walls 12 in a grid pattern are formed in a manner containing each first electrode 15 in a planar view. Hereinafter, areas surrounded by the partition walls 12 are also referred to as depressed portions 19. Shapes of the depressed portions 19 correspond to depressions defined by the partition walls 12 and the support substrate 13. In the present embodiment, the depressed portions 19 are set on the support substrate 13. The depressed portions 19 are arranged in a matrix pattern on the support substrate 13, corresponding to the partition walls 12 in a grid shape. In the present embodiment, the depressed portions 19 correspond to the sections defined by the partition walls.

It is preferable that the partition walls 12 be formed so that surfaces of the partition walls 12 facing the first electrode 15 becomes more separate from the first electrode 15 as a distance from the support substrate 13 increases. More specifically, when the depressed portions 19 are sectioned by a plane perpendicular to the thickness direction Z of the support substrate 13, it is preferable that cross-sectional shapes of the depressed portions 19 become larger as a distance from the support substrate 13 increases, and the partition walls 12 are preferably formed in a so-called forward tapered shape. The partition walls 12 in such a forward tapered shape can be formed more easily than partition walls in a so-called inverse tapered shape. In addition, with respect to the partition walls 12 in a forward tapered shape, compared to partition walls in a so-called inverse tapered shape, when forming the partition walls 12 by a photolithography method, a residue in a development step is less likely to remain near ends of tapers, and also surfaces thereof can be washed cleanly in a washing step such as water washing performed as necessary.

The organic EL elements 14 are provided on sections defined by the partition walls. In the present embodiment, the organic EL elements 14 each are provided on areas (i.e., the depressed portions 19) surrounded by the partition walls 12. As described above, because the depressed portions 19 are arranged in a matrix pattern, the organic EL elements 14 also are arranged in an aligned manner in a matrix pattern in the present embodiment. More specifically, the organic EL elements 14 each are arranged at a predetermined interval in the row direction X and also at a predetermined interval in the column direction Y Note that the organic EL elements 14 do not have to be physically separate from each other, but should be electrically insulated so as to be driven individually. Accordingly, some (a second electrode 18 described later in the present embodiment) of layers constituting each of the organic EL elements may be physically connected with another organic EL element.

Each of the organic EL elements 14 is configured by laminating the first electrode 15, organic EL layers 16 and 17, and the second electrode 18 in this order from the vicinity of the support substrate 13.

The first electrode 15 and the second electrode 18 constitute a pair of electrodes composed of an anode and a cathode. More specifically, one of the first electrode 15 and the second electrode 18 is provided as the anode, and the other is provided as the cathode. In addition, the first electrode 15 out of the first electrode 15 and the second electrode 18 is arranged near the support substrate 13, and the second electrode 18 is arranged further apart from the support substrate 13 than the first electrode 15.

Each of the organic EL elements 14 includes one or more organic EL layers. Note that the organic EL layers represent all layers interposed between the first electrode 15 and the second electrode 18. Each of the organic EL elements 14 includes at least one or more light-emitting layers as the organic EL layers. In addition, between the electrodes 15 and 18, without being limited to light-emitting layers, predetermined layers are provided as necessary. For example, between the anode and the light-emitting layers, as organic EL layers, a hole injection layer, a hole transport layer, an electron-blocking layer, and the like are provided, and between the light-emitting layers and the cathode, as organic EL layers, a hole-blocking layer, an electron transport layer, an electron injection layer, and the like are provided.

Each of the organic EL elements 14 of the present embodiment includes a hole injection layer 16 as an organic EL layer between the first electrode 15 and these light-emitting layers 17.

Hereinafter, as one embodiment, the organic EL elements 14 each of which is configured by laminating the first electrode 15 functioning as an anode, the hole injection layer 16, the light-emitting layers 17, and the second electrode 18 functioning as a cathode in this order from the vicinity of the support substrate 13 will be described.

Because the light emitting device 11 of the present embodiment is a device of an active matrix type, the first electrode 15 is provided individually for each of the organic EL elements 14. More specifically, the first electrode 15 is provided in the same number as the number of the organic EL elements 14 on the support substrate 13. For example, the first electrode 15 is in a shape of a thin film, and is formed in a substantially rectangular shape in a planar view. The first electrode 15 is provided in plurality on the support substrate 13 in a matrix pattern corresponding to positions where the respective organic EL elements are provided, and each is arranged at a predetermined interval in the row direction X and also at a predetermined interval in the column direction Y.

The first electrode 15 is arranged so that at least part of the first electrode 15 is separate from the partition walls 12 on the support substrate. In the present embodiment, the first electrode 15 is provided in each of the depressed portions 19 in a planar view, and the whole outer border thereof is arranged apart from the partition walls 12.

The hole injection layer 16 is provided on the first electrode 15 in each of the depressed portions 19. Note that the hole injection layer 16 is provided not only on the first electrode 15 but also extending from the first electrode 15 to the partition walls 12. In other word, the hole injection layer 16 is provided also between the first electrode 15 and the partition walls 12.

In the present specification, out of the organic EL layers (the hole injection layer 16 and the light-emitting layers 17 in the present embodiment), a portion provided between the first electrode 15 and the partition walls 12 is referred to as an extension portion 20. A surface of a member in contact with the bottom face of the extension portion 20 exhibits a higher lyophilic property than that of surfaces of the partition walls. Note that in the present specification, when a plurality of organic EL layers are provided between the first electrode 15 and the second electrode 18, out of a laminate of the organic EL layers, whole portion provided between the first electrode 15 and the partition walls 12 in a planar view is referred to as the extension portion. In addition, when a plurality of organic EL layers are provided between the first electrode 15 and the second electrode 18, a plurality of surfaces (planes) exist on the extension portion made of the laminate, and a plane that is closest to the support substrate out of the planes is referred to as a bottom face of the extension portion. More specifically, in the present embodiment, two layers of the hole injection layer 16 and the light-emitting layers 17 are provided as organic EL layers, and a plane of the extension portion 20 of the hole injection layer 16 on the side of the support substrate corresponds to the above-mentioned bottom face of the extension portion. In the present embodiment, the member in contact with the bottom face of the extension portion 20 corresponds to the support substrate 13.

The light-emitting layers 17 are provided on the hole injection layer 16 in each of the depressed portions 19.

The light emitting device of the present invention can be applied to a monochrome display device, but in the present embodiment, the light emitting device applied to a color display device will be described as one example. In the case of a color display device, three types of organic EL elements each of which emits one of red, green, and blue light are provided on the support substrate 13. The color display device can be fabricated by repeatedly arranging the following rows (I), (II), and (III) in this order in the column direction Y.
(I) A row in which a plurality of organic EL elements 14R emitting red light are arranged at a predetermined interval in the row direction X
(II) A row in which a plurality of organic EL elements 14G emitting green light are arranged at the predetermined interval in the row direction X
(III) A row in which a plurality of organic EL elements 14B emitting blue light are arranged at the predetermined interval in the row direction X

When forming three types of organic EL elements 14R, 14G, and 14B whose luminescent colors are different in this manner, light-emitting layers whose luminescent colors are different are generally provided for the respective types of elements. In the present embodiment, the following rows (i), (ii), and (iii) are repeatedly arranged in this order in the column direction Y.
(i) A row in which a light-emitting layer 17 emitting red light is provided
(ii) A row in which a light-emitting layer 17 emitting green light is provided
(iii) A row in which a light-emitting layer 17 emitting blue light is provided

In this case, three types of light-emitting layers 17 each are sequentially laminated on the hole injection layer 16 at a two-row interval in the column direction Y.

The second electrode 18 is provided on the light-emitting layers 17. Note that in the present embodiment, the second electrode 18 is formed continuously over a plurality of organic EL elements 14, and is provided as a common electrode for the organic EL elements 14. The second electrode 18 is formed not only on the light-emitting layers 17 but also on the partition walls 12, and is formed all over the light emitting device so that electrodes on the light-emitting layers 17 and electrodes on the partition walls 12 lie continuously.

### <Production Method of Light Emitting Device>

A production method of the light emitting device will be described hereinafter.

### (Step of Preparing Support Substrate)

In the present step, the support substrate 13 on which the first electrode 15 is provided is prepared. In the case of a display device of an active matrix type, a substrate on which a circuit for individually driving a plurality of organic EL elements is formed in advance can be used as the support substrate 13. For example, a substrate on which a thin film transistor (TFT), a capacitor, and the like are formed in advance can be used as the support substrate. It is acceptable to prepare the support substrate 13 on which the first electrode 15 by forming the first electrode 15 in the present step as described below, and also it is acceptable to prepare the support substrate 13 by obtaining at the market the support substrate 13 on which the first electrode 15 is provided in advance. Furthermore, it is acceptable to prepare the support substrate 13 by obtaining at the market the support substrate 13 on which the first electrodes 15 and the partition walls 12 are provided in advance.

Next, the first electrode 15 is formed in plurality in a matrix pattern on the support substrate 13. The first electrode 15 is formed in plurality by forming a conductive thin film on a whole surface of the support substrate 13 and patterning this in a matrix pattern by a photolithography method. Alternatively, it is acceptable to pattern-form the first electrode 15 in plurality by arranging on the support substrate 13 a mask in predetermined portions of which openings are formed and selectively laminating a conductive material on the predetermining portions on the support substrate 13 through this mask. Material of the first electrode 15 will be described later.

Next, the partition walls 12 on the support substrate 13 are formed. In the present embodiment, the partition walls 12 in a grid pattern are formed. The partition walls 12 contain organic substances or inorganic substances. Examples of the organic substances constituting the partition walls 12 include an acrylic resin, a phenolic resin, a polyimide resin, and other resins. In contrast, examples of the inorganic substances constituting the partition walls 12 include SiOX and SiNX.

The partition walls 12 preferably contain organic substances. To retain ink supplied into the depressed portions 19 within the depressed portions 19, partition walls surrounding the depressed portions 19 preferably exhibit a liquid-repellent property. This is because organic substances exhibit a higher liquid-repellent property than inorganic substances in general and thus, with organic substances constituting the partition walls, it is possible to improve capability of retaining ink within the depressed portions 19.

When forming the partition walls 12 containing organic substances, apply a positive or negative photosensitive resin, for example, to the whole surface first, and expose the predetermined portions to light to develop them. Furthermore, by curing them, the partition walls 12 in a grid pattern are formed. Alternatively, it is possible to use a photoresist as the photosensitive resin. In contrast, when forming the partition walls 12 containing inorganic substances, form a thin film containing inorganic substances, for example, by a plasma CVD method or sputtering method on the whole surface, and then remove the predetermined portions to form the partition walls 12 in a grid pattern. Removing the predetermined portions is performed by a photolithography method, for example.

A shape of the partition walls 12 and arrangement thereof are appropriately set depending on specifications of the display device such as the number of pixels and resolution, ease of production, and other conditions. For example, widths L1 and L2 of each of the partition walls 12 in the row direction X and in the column direction Y are about 5 micrometers to 50 micrometers each, a height L3 of the partition walls 20 is about 0.5 micrometer and 5 micrometers, and intervals L4 and L5 between the partition walls 20 in the row direction X and in the column direction Y, i.e., widths L4 and L5 of each of the depressed portions 19 in the row direction X and in the column direction Y are about 20 micrometers to 1000 micrometers each. In addition, the widths of the first electrode 15 in the in the row direction X and in the column direction Y are about 20 micrometers to 1000 micrometers each. In addition, a spacing L6 between the first electrode 15 and the partition walls 12 is about 2 micrometers to 20 micrometers.

After forming the partition walls 12, the partition walls 12 are subjected to a liquid-repellent process as necessary. For example, when the partition walls 12 are formed of organic substances, perform a plasma process in an atmosphere containing a fluoride such as CF4. In such a plasma process, surfaces of the first electrode 15 and the support substrate 11 containing inorganic substances maintain their lyophilic properties, but in contrast, fluorine atoms bind to surfaces of the partition walls 12, making it possible to render the partition walls 12 liquid-repellent. In this manner, it is possible to selectively subject only the partition walls 12 to the liquid-repellent process.

### (Step of Forming Organic EL Layers)

In the present step, the hole injection layer 16 and the light-emitting layers 17 are formed as organic EL layers. To begin with, ink (hereinafter, also referred to as ink for hole injection layer) containing material to be an organic EL layer (the hole injection layer in the present embodiment) is supplied onto the support substrate 13 to form a thin film made of ink for hole injection layer.

In the present embodiment, the hole injection layer 16 that is common for all of the organic EL elements 14 is formed. Accordingly, it is not necessary to supply the ink for hole injection layer exclusively into the depressed portions 19, so that it is acceptable to supply the ink for hole injection layer onto the whole surface and also acceptable to supply the ink for hole injection layer by any method. For example, it is possible to supply the ink for hole injection layer by a spin coating method, an inkjet printing method, a nozzle printing method, a letterpress printing method, or an intaglio printing method. Note that when the ink for hole injection layer is applied onto the whole surface, there are occasions when a hole injection layer is formed even on the partition walls depending on properties and condition of surfaces of the partition walls and accordingly, in order to avoid this, it is preferable to supply the ink for hole injection layer only into the depressed portions 19 in some cases. In such cases, the ink for hole injection layer is supplied by a coating method making it possible to selectively supply the ink for hole injection layer only into the depressed portions 19. Examples of the coating method making it possible to selectively supply the ink into each of the depressed portions 19 include an inkjet printing method, a letterpress printing method, and an intaglio printing method.

The solid concentration of the ink used, although depending on a coating method, is generally on the order of several percent at the highest. Accordingly, a large amount of ink compared to volume of the hole injection layer 16 is supplied into the depressed portions 19. Because the first electrode 15 is arranged apart from the partition walls 12 on the support substrate 13, the ink for hole injection layer supplied into the depressed portions 19 is supplied not only onto the first electrode 15 but also between the first electrode 15 and the partition walls 12, and further supplied onto sides of the partition walls 12.

Note that the bottom face of the extension portion between the first electrode 15 and the partition walls 12 corresponds to the surface of the support substrate 13 in the present embodiment. The surface portion of the support substrate 13 regularly contains inorganic substances, and thus exhibits a higher lyophilic property than that of the partition walls 12 if it is not subjected to a special process. Similarly, the first electrode 15 also contains inorganic substances, and thus exhibits a higher lyophilic property than that of the partition walls 12 if it is not subjected to a special process. In contrast, the surfaces of the partition walls 12 in the present embodiment exhibit a higher liquid-repellent property than that of the bottom face between the first electrode 15 and the partition walls 12 and also that of the surface of the first electrode 15. Note that the lyophilic property and the liquid-repellent property represent wettability to ink supplied into the depressed portions 19. The level of wettability can be represented by a contact angle with ink, and a larger contact angle indicates a higher liquid-repellent property. The contact angle of ink as an index of wettability herein is defined by a contact angle with anisole in the present specification.

The ink for hole injection layer supplied into the depressed portions 19 becomes a thin film, shrinking its volume, because the solvent gradually vaporizes. As described above, compared to the bottom face between the first electrode 15 and the partition walls 12 (the surface of the support substrate in the present embodiment), the surfaces of the partition walls 12 exhibit a high liquid-repellent property to ink and accordingly, the ink, while wetting the bottom face between the first electrode 15 and the partition walls 12 and spreading thereover, shrinks its volume to become a thin film, being rejected by the surfaces of the partition walls 12. Because the ink becomes a thin film while being rejected by the partition walls in this manner, there are occasions when film thickness of the thin film at a boundary area between the bottom face between the first electrode 15 and the partition walls 12 and the partition walls becomes extremely small in conventional techniques.

However, in the present embodiment, because the bottom face between the first electrode 15 and the partition walls 12 and the surface of the first electrode 15 have higher lyophilic properties than that of the surfaces of the partition walls 12, the ink becomes a thin film while wetting the bottom face and the first electrode 15 and spreading thereover. Accordingly, the film thickness of the thin film near the outer border of the first electrode 15 will not become extremely small, and a thin film having a uniform film thickness can be obtained on the first electrode 15.

In this manner, in each of the depressed portions 19, a thin film having a uniform film thickness containing ink for hole injection layer is formed on the first electrode 15. An organic layer (the hole injection layer 16 in the present embodiment) is formed with the ink supplied into each of the depressed portions 19 solidifying. On the first electrode 15, a thin film having a uniform film thickness containing the ink for hole injection layer can be obtained, and accordingly by solidifying this thin film, it is possible to form the hole injection layer 16 having a uniform film thickness on the first electrode 15.

Solidification of ink can be performed by removing solvent, for example. Removal of the solvent can be performed by natural drying, drying by heating, vacuum drying, or the like. Alternatively, when ink used contains material that polymerizes with energy such as light and heat applied, it is acceptable to solidify the organic layer by applying energy such as light and heat after supplying the ink.

Next, form the light-emitting layers 17. As described above, when fabricating a color display device, it is necessary to fabricate three types of organic EL elements. This requires applying material for the light-emitting layer in a distinctive manner on a row-by-row basis. For example, when forming three types of light-emitting layers 17 on a row-by-row basis, it is necessary to apply red ink containing material that emits red light, green ink containing material that emits green light, and blue ink containing material that emits blue light each at a two-row interval in the column direction Y. By sequentially applying the red ink, the green ink, and the blue ink to the predetermined rows, it is possible film-form each of the light-emitting layers 17.

As a method for sequentially applying the red ink, the green ink, and the blue ink to the predetermined rows, any method is acceptable as long as it is a coating method making it possible to selectively supply ink into the depressed portions 19. For example, by an inkjet printing method, a nozzle printing method, a letterpress printing method, or an intaglio printing method, it is possible to supply ink into each of the depressed portions 19.

An organic layer (the light-emitting layers in the present embodiment) is formed by solidifying ink supplied into each of the depressed portions 19. Solidification of ink can be performed by removing solvent, for example. Removal of the solvent can be performed by natural drying, drying by heating, vacuum drying, or the like. Alternatively, when ink used contains material that polymerizes with energy such as light and heat applied, it is acceptable to solidify the organic layer by applying energy such as light and heat after supplying the ink.

After forming the light-emitting layers 17, a predetermined organic layer, an inorganic layer, and the like are formed by a predetermined method as necessary. These may be formed by a predetermined coating method such as a printing method, an inkjet method, and a nozzle printing method, or also by a predetermined dry method.

### (Step of Forming Second Electrode)

Next, the second electrode is formed. As described above, in the present embodiment, the second electrode 18 is formed all over the support substrate 13. In this manner, it is possible to form the organic EL elements 14 on the substrate.

As described above, because the first electrode 15 is arranged apart from the partition walls 12 on the support substrate 13 and also the surface of the member in contact with the bottom face of the extension portion 20 exhibits a higher lyophilic property than that of surfaces of the partition walls 12, it is possible to form the hole injection layer 16 having a uniform film thickness on the first electrode 15. In the present embodiment, because luminescence of each of the organic EL elements 14 occurs in an area where the first electrode 15 and the second electrode 18 overlap in a planar view, by forming the hole injection layer 16 having a uniform film thickness on the first electrode 15, it is possible to obtain uniform luminescence within a light-emitting area.

Note that there may be occasions when thickness of the extension portion 20 of the hole injection layer 16 formed between the first electrode 15 and the partition walls 12 becomes extremely smaller than the film thickness of the hole injection layer 16 on the first substrate 15. However, because the extension portion 20 does not contribute to luminescence, even if thickness of the hole injection layer 16 on the first electrode 15 differs from that of the extension portion 20, this ununiformity of film thickness will not exert a visible effect on a light-emitting state of the organic EL elements 14. However, in the case that the thickness of the extension portion 20 is extremely smaller than the thickness of the organic EL layer on the first electrode 15, when the member in contact with the bottom surface of the extension portion 20 contains a conductive member, it is likely that the second electrode 18 and the conductive member become electrically continuous via the extension portion 20 and a leak current occurs. Accordingly, the member in contact with the bottom face of the extension portion 20 preferably contains an electrically insulating member.

For example, when the support substrate 13 includes a glass plate, the extension portion 20 is preferably provided in contact with the glass plate exhibiting an electrically insulating property. More specifically, the first electrode 15, the extension portion 20 and the partition walls 12 are preferably formed on the same surface of the glass plate. In this manner, by forming the extension portion 20 on the glass plate exhibiting an electrically insulating property, even if the extension portion 20 having an extremely small film thickness is formed, it is possible to prevent a leak current that flows through the extension portion 20.

In addition, when the support substrate 13 is configured to include a metal thin film, for example, and an insulating film is formed on surface portion thereof, the first electrode 15, the partition walls 12, and the extension portion 20 are preferably arranged in contact with the insulating film. In this manner, by forming the extension portion 20 on the insulating film, even if the extension portion 20 having an extremely small film thickness is formed, it is possible to prevent a leak current that flows through the extension portion 20. Note that such an insulating film contains a member whose surface exhibits a higher lyophilic property than that of the partition walls, and contains inorganic substances such as SiOX and SiNX described above, for example.

In the light emitting device of the present embodiment described above, it is assumed that the first electrode 15 is provided in each of the depressed portions 19 in a planar view and the whole of outer border thereof is arranged apart from the partition walls, but the first electrode may be arranged partially apart from the partition walls. More specifically, the partition walls may be arranged overlapping part of circumferential portion of the first electrode.

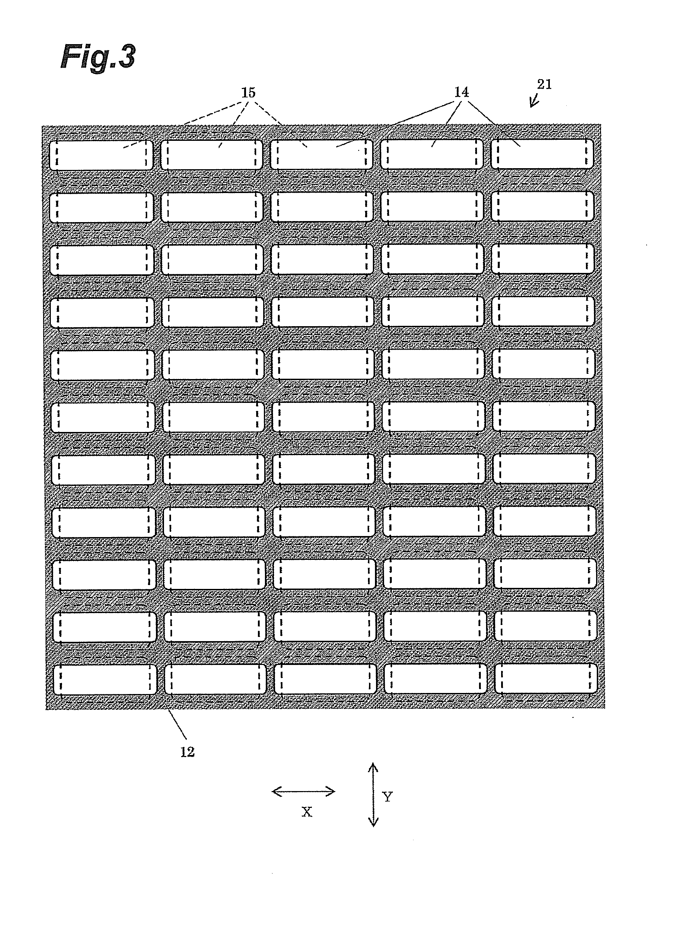

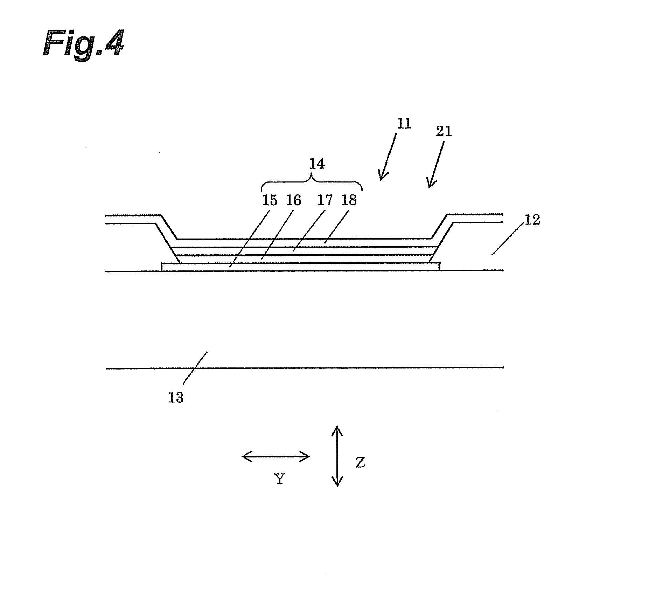

Fig. 3 is a plan view schematically illustrating a light emitting device 21 according to another embodiment of the present invention. Fig. 4 is a sectional view schematically illustrating the light emitting device 21 in an enlarged manner when sectioned by a plane perpendicular to the row direction X. Note that a sectional view of the light emitting device 21 when sectioned by a plane perpendicular to the column direction Y is the same as Fig. 2.

To the light emitting devices 11 and 21 in a planar view, without being limited to organic EL elements 14 in a substantially rectangular shape, organic EL elements 14 in various shapes are provided. For example, organic EL elements 14 having a shape extending in a predetermined longitudinal direction such as a substantially rectangular shape, a substantially elliptical shape, and an oval shape. In this case, the first electrode 15 also has a shape extending in the predetermined longitudinal direction. When the first electrode 15 has the shape extending in the predetermined longitudinal direction, one end and the other end of the first electrode 15 in the longitudinal direction are preferably arranged apart from the partition walls 12. Note that in the light emitting device 11 of the above-described embodiment depicted in Fig. 1, one end and the other end of the first electrode 15 in the longitudinal direction are arranged apart from the partition walls 12.

Fig. 3 illustrates the organic EL elements 14 that have the first electrode 15 in a substantially rectangular shape extending in the row direction X as one example. More specifically, in the present embodiment, the row direction X corresponds to the predetermined longitudinal direction. In the present embodiment, the partition walls 12 are formed so as to be arranged at a predetermined spacing from one end of the first electrode 15 in the row direction X (longitudinal direction), and also arranged at the predetermined spacing from the other end of the first electrode 15 in the row direction X (longitudinal direction). On the other hand, the partition walls 12 are formed so as to cover one end portion of the first electrode in the column direction Y and also cover the other end portion thereof in the column direction Y More specifically, in the present embodiment, the partition walls 12 are formed mainly on areas excluding the first electrode 15, and part thereof is formed so as to cover the one end portion and the other end portion of the first electrode in the column direction Y. Note that the column direction Y corresponds to the lateral direction of the first electrode 15.

The ink supplied into the depressed portions 19 becomes a thin film while shrinking with the solvent vaporizing, and at this time, a force acts on the ink such that it becomes spherical due to surface tension. Because a deviation of the shape of ink from a spherical shape is larger in the longitudinal direction than in the lateral direction, than a force in a direction shrinking in the column direction Y (lateral direction), a force in a direction shrinking in the row direction X (longitudinal direction) becomes larger. Note that a force with which ink is repelled by the partition walls acts on the ink, and accordingly there are occasions when this force and a force in the direction of becoming spherical combine, and the film thickness of the end portions in the row direction X (longitudinal direction) becomes larger than the film thickness of the end portions in the column direction Y (lateral direction). In the present embodiment, at the end portions in the row direction X where there is a strong tendency for the film thickness to become smaller, predetermined spacings are provided between the partition walls 12 and the first electrode 15, and accordingly in the same manner as the above-described embodiment, it is possible to form an organic EL layer having a relatively uniform film thickness on the first electrode 15. Furthermore, even if the extension portion 20 having an extremely small film thickness at the end portions in the row direction X, it is possible to prevent a leak current that flows through the extension portion 20 in the same manner as the foregoing.

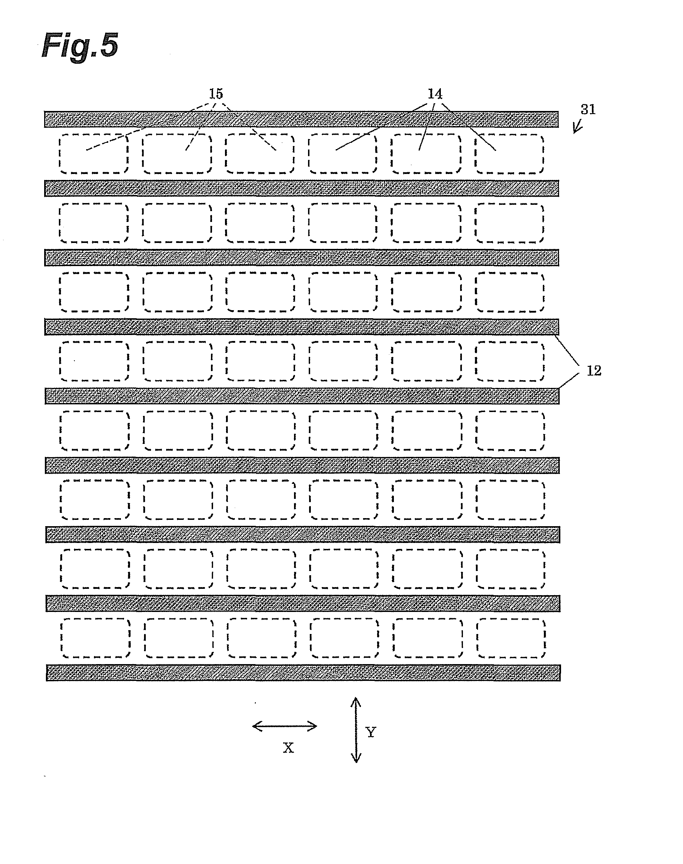

The light emitting device provided with the partition walls 12 in a grid pattern has been described in the present embodiment, but the shape of the partition walls is not limited to the grid pattern. The present invention can also be applied to a light emitting device provided with partition walls in a strip pattern. Fig. 5 is a pan view schematically illustrating a light emitting device 31 provided with a plurality of partition walls extending in the row direction X. As depicted in Fig. 5, the first electrode 15 is arranged apart from the partition walls 12 on the support substrate 13. By spacing the first electrode 15 and the partition walls 12 in this manner, in the same manner as the above-described embodiment, on the first electrode 15, it is possible to form an organic EL layer having a relatively uniform film thickness. Furthermore, even if the extension portion 20 having an extremely small film thickness at the end portions in the row direction X is formed, it is possible to prevent a leak current that flows through the extension portion 20 in the same manner as the foregoing.

### <Structure of Organic EL Element>

The organic EL elements 14 can have various layer structures as described above, and a layer structure of the organic EL elements 14, a structure of each layer, and a forming method of each layer will be described in more detail below.

As described above, an organic EL element is configured to include a pair of electrodes composed of an anode and a cathode (the first and second electrodes) and one or more organic EL layers provided between the electrodes, and has at least one light-emitting layer as the one or more organic EL layers. Note that the organic EL element may include a layer containing an inorganic substance and an organic substance, an inorganic layer, and the like. The organic substance constituting the organic layers may be a low-molecular-weight compound or a polymer compound, and also may be a mixture of a low-molecular-weight compound and a polymer compound. The organic layers preferably contain a polymer compound, and preferably contain a polymer compound having a number average molecular weight of 103 to 108 in terms of polystyrene.

Examples of the organic EL layers provided between the cathode and the light-emitting layer include an electron injection layer, an electron transport layer, and a hole-blocking layer. When both of the electron injection layer and the electron transport layer are provided between the cathode and the light-emitting layer, the layer close to the cathode is referred to as the electron injection layer, and the layer close to the light-emitting layer is referred to as the electron transport layer. Examples of the organic EL layers provided between the anode and the light-emitting layer include a hole injection layer, a hole transport layer, and an electron-blocking layer. When both of the hole injection layer and the hole transport layer are provided, the layer close to the anode is referred to as the hole injection layer, and the layer close to the light-emitting layer is referred to as the hole transport layer.

Examples of possible layer structures of the organic EL element of the present embodiment are listed below.
a) anode / light-emitting layer / cathode
b) anode / hole injection layer / light-emitting layer / cathode
c) anode / hole injection layer / light-emitting layer / electron injection layer / cathode
d) anode / hole injection layer / light-emitting layer / electron transport layer / cathode
e) anode / hole injection layer / light-emitting layer / electron transport layer / electron injection layer / cathode
f) anode / hole transport layer / light-emitting layer / cathode
g) anode / hole transport layer / light-emitting layer / electron injection layer / cathode
h) anode / hole transport layer / light-emitting layer / electron transport layer / cathode
i) anode / hole transport layer / light-emitting layer / electron transport layer / electron injection layer / cathode
j) anode / hole injection layer / hole transport layer / light-emitting layer / cathode
k) anode / hole injection layer / hole transport layer / light-emitting layer / electron injection layer / cathode
l) anode / hole injection layer / hole transport layer / light-emitting layer / electron transport layer / cathode
m) anode / hole injection layer / hole transport layer / light-emitting layer / electron transport layer / electron injection layer / cathode
n) anode / light-emitting layer / electron injection layer / cathode
o) anode / light-emitting layer / electron transport layer / cathode
p) anode / light-emitting layer / electron transport layer / electron injection layer / cathode
(Here, the mark "/" indicates that the respective layers sandwiching the mark "/" are laminated adjacent to each other. The same applies hereinafter.)

The organic EL element of the present embodiment may have two or more light-emitting layers. In any one of the layer structures a) to p) listed above, when referring to a laminate held between the anode and the cathode as a "structural unit A", examples of a structure of the organic EL element having two light-emitting layers include the layer structure indicated in q) below. Note that the layer structures of the (structural unit A) appearing twice may be the same or different from each other.
q) anode / (structural unit A) / charge-generating layer / (structural unit A) / cathode

In addition, when referring to the "(structural unit A) /charge-generating layer" as a "structural unit B", examples of a structure of the organic EL element having three or more light-emitting layers include the layer structure indicated in r) below.
r) anode / (structural unit B)x / (structural unit A) / cathode

Note that the mark "x" indicates an integer equal to or more than two, and (structural unit B)x indicates a laminate with x layers of structural unit B being laminated. Layer structures of a plurality of (structural unit B) may be the same or different from each other.

Here, the charge-generating layer is a layer that generates holes and electrons by applying an electric field. Examples of the charge-generating layer include a thin film made of, for example, vanadium oxide, indium tin oxide (ITO), or molybdenum oxide.

It is acceptable to provide the organic EL element with the anode out of the pair of electrodes composed of the anode and the cathode arranged nearer the support substrate than the cathode on the support substrate, or it is acceptable to provide the organic EL element with the cathode arranged nearer the support substrate than the anode on the support substrate. For example, in the above-listed a) to r), it is acceptable to laminate the respective layers in order from the right on the support substrate to constitute the organic EL element, or it is acceptable to laminate the respective layers in order from the left on the support substrate to constitute the organic EL element. It is possible to appropriately set order of layers to be laminated, the number of the layers, and thicknesses of the respective layers in consideration of light emission efficiency or the product life of the element.

Materials of the respective layers constituting the organic EL element and a forming method thereof will be described more specifically below.

### <Anode>

For the organic EL element having a structure in which light emitted from the light-emitting layer exits through the anode to the outside of the element, an electrode exhibiting optical transparency is used for the anode. As the electrode exhibiting optical transparency, a thin film of metal oxide, metal sulfide, metal, and the like is usable, and one having high electric conductivity and high optical transparency is preferably used. More specifically, a thin film made of indium oxide, zinc oxide, tin oxide, ITO, indium zinc oxide (IZO), gold, silver, platinum, or copper is used, and among these, a thin film made of ITO, IZO, or tin oxide is preferably used.

Examples of a production method of the anode include a vacuum deposition method, a sputtering method, an ion plating method, and a plating method. Alternatively, as the anode, it is acceptable to use an organic transparent conductive film such as polyaniline or derivatives thereof and polythiophene or derivatives thereof.

The film thickness of the anode is appropriately set in view of required properties, simplicity of the film forming process, and other conditions, and is 10 nanometers to 10 micrometers, for example, preferably 20 nanometers to 1 micrometer, and more preferably 30 nanometers to 300 nanometers.

### <Cathode>

As material for the cathode, one that has a small work function, facilitates electron injection into the light-emitting layer, and has high electric conductivity is preferable. In addition, for the organic EL element configured to extract light from the anode side, in which light emitted from the light-emitting layer is reflected by the cathode to the anode side, material having high reflectivity to visible light is preferable as material for the cathode. For the cathode, for example, an alkali metal, an alkali earth metal, a transition metal, or a metal of Group 13 of the periodic table is usable. Examples of the material for the cathode may include metals such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium, an alloy of two or more of the metals, an alloy of one or more of the metals and one or more of gold, silver, platinum, copper, manganese, titanium, cobalt, nickel, tungsten, and tin, and graphite or a graphite interlayer compound. Examples of the alloys include magnesium-silver alloy, magnesium-indium alloy, magnesium-aluminum alloy, indium-silver alloy, lithium-aluminum alloy, lithium-magnesium alloy, lithium-indium alloy, and calcium-aluminum alloy. In addition, as the cathode, it is possible to use a transparent conductive electrode made of conductive metal oxide, a conductive organic substance, and the like. More specifically, examples of the conductive metal oxide include indium oxide, zinc oxide, tin oxide, ITO, and IZO, and examples of the conductive organic substance include polyaniline or derivatives thereof, and polythiophene or derivatives thereof. Noted that the cathode may be configured with a laminate with two or more layers laminated. Also, the electron injection layer may be used as the cathode in some cases.

The film thickness of the cathode is appropriately set in view of required properties, simplicity of the film forming process, and other conditions, and is 10 nanometers to 10 micrometers, for example, preferably 20 nanometers to 1 micrometer, and more preferably 50 nanometers to 500 nanometers.

Examples of a production method of the cathode include a vacuum deposition method, a sputtering method, and a lamination method of performing thermocompression bonding of a metal thin film.

### <Hole Injection Layer>

Examples of a hole injection material constituting the hole injection layer include oxides such as vanadium oxide, molybdenum oxide, ruthenium oxide, and aluminum oxide, a phenylamine-based material, a starburst type amine-based material a phthalocyanine-based material, amorphous carbon, polyaniline, and a polythiophene derivative.

The film thickness of the hole injection layer is appropriately set in view of required properties, simplicity of the film forming process, and other conditions, and is 1 nanometer to 1 micrometer, for example, preferably 2 nanometers to 500 nanometers, and more preferably 5 nanometers to 200 nanometers.

### <Hole Transport Layer>

Examples of a hole transport material constituting the hole transport layer include polyvinylcarbazole or derivatives thereof, polysilane or derivatives thereof, a polysiloxane derivative having aromatic amine at a side chain or the main chain, a pyrazoline derivative, an arylamine derivative, a stilbene derivative, a triphenyldiamine derivative, polyaniline or derivatives thereof, polythiophene or derivatives thereof, polyarylamine or derivatives thereof, polypyrrole or derivatives thereof, poly(p-phenylenevinylene) or derivatives thereof, and poly(2,5-thienylenevinylene) or derivatives thereof.

The film thickness of the hole transport layer is set in view of required properties, simplicity of the film forming process, and other conditions, and is 1 nanometer to 1 micrometer, for example, preferably 2 nanometers to 500 nanometers, and more preferably 5 nanometers to 200 nanometers.

### <Light-Emitting Layer>

The light-emitting layer is generally formed primarily from an organic substance emitting fluorescent and/or phosphorescent light, or the organic substance and a dopant for assisting this. The dopant is added for the purpose of improving light emission efficiency or changing an emission wavelength, for example. Note that the organic substance constituting the light-emitting layer may be a low-molecular-weight compound or a polymer compound and, in the case of forming the light-emitting layer by the coating method, it is preferable that the light-emitting layer contain the polymer compound. The number average molecular weight of the polymer compound constituting the light-emitting layer in terms of polystyrene is about 103 to 108, for example. Examples of the light-emitting material constituting the light-emitting layer include a dye-based material, a metal complex-based material, a polymer-based material, and a dopant material enumerated below.

### (Dye-Based Material)

Examples of the dye-based material include a cyclopendamine derivative, a tetraphenylbutadiene derivative, a triphenylamine derivative, an oxadiazole derivative, a pyrazoloquinoline derivative, a distyrylbenzene derivative, a distyrylarylene derivative, a pyrrole derivative, a thiophene ring compound, a pyridine ring compound, a pelynone derivative, a perylene derivative, an oligothiophene derivative, an oxadiazole dimmer, a pyrazoline dimmer, a quinacridone derivative, and a coumarin derivative.

### (Metal Complex-Based Material)

Examples of the metal complex-based material include a metal complex having a rare earth metal (e.g., Tb, Eu, or Dy), Al, Zn, Be, Ir, Pt, or the like as a central metal, and having oxadiazole, thiadiazole, phenylpyridine, phenylbenzoimidazole, a quinoline structure, or the like as a ligand, and examples thereof include a metal complex emitting light from a triplet excited state such as an iridium complex and platinum complex, an aluminum quinolinol complex, a benzoquinolinol beryllium complex, a benzooxazole zinc complex, a benzothiazole zinc complex, an azomethyl zinc complex, a porphyrin zinc complex, and a phenanthroline europium complex.

### (Polymer-Based Material)

Examples of the polymer-based material include a polyparaphenylene vinylene derivative, a polythiophene derivative, a polyparaphenylene derivative, a polysilane derivative, a polyacetylene derivative, a polyfluorene derivative, a polyvinylcarbazole derivative, and those obtainable by polymerizing the dye-based material and metal complex-based light-emitting material.

The thickness of the light-emitting layer is generally about 2 nanometers to 200 nanometers.

### <Electron Transport Layer>

As an electron transport material constituting the electron transport layer, it is possible to use a publicly-known one, and examples thereof include an oxadiazole derivative, anthraquino-dimethane or derivatives thereof, benzoquinone or derivatives thereof, naphthoquinone or derivatives thereof, anthraquinone or derivatives thereof, tetracyanoanthraquino-dimethane or derivatives thereof, a fluorenone derivative, diphenyldicyanoethylene or derivatives thereof, a diphenoquinone derivative, 8-hydroxyquinoline or metal complexes of derivatives thereof, polyquinoline or derivatives thereof, polyquinoxaline or derivatives thereof, and polyfluorene or derivatives thereof.

The film thickness of the electron transport layer is appropriately set in view of required properties, simplicity of the film forming process, and other conditions, and is 1 nanometer to 1 micrometer, for example, preferably 2 nanometers to 500 nanometers, and more preferably 5 nanometers to 200 nanometers.

### <Electron Injection Layer>

As an electron injection material constituting the electron injection layer, an optimum material is appropriately selected depending on the type of the light-emitting layer, and examples thereof include an alkali metal, an alkali earth metal, an alloy containing one or more types of metals out of alkali metals and alkali earth metals, an oxide, a halide, and a carbonate of an alkali metal or an alkali earth metal, and a mixture of these substances. Examples of the alkali metal and the oxide, the halide, and the carbonate of the alkali metal include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, and lithium carbonate. In addition, examples of the alkali earth metal and the oxide, the halide, and the carbonate of the alkali earth metal include magnesium, calcium, barium, strontium, magnesium oxide, magnesium fluoride, calcium oxide, calcium fluoride, barium oxide, barium fluoride, strontium oxide, strontium fluoride, and magnesium carbonate. The electron injection layer may be constituted by a laminate that is prepared by laminating two or more layers, and examples thereof include a laminate of LiF/Ca.

The film thickness of the electron injection layer is preferably about 1 nanometer to 1 micrometer.

When among the organic EL layers there are a plurality of organic EL layers that can be formed by a coating method, it is preferable to form all of the organic EL layers by the coating method, but it is acceptable to form by the coating method at least one layer out of the organic EL layers that can be formed by the coating method, and form the other organic EL layers by a method different from the coating method. In addition, even when forming a plurality of organic EL layers by the coating method, it is acceptable to form the organic EL layers by coating methods concrete methods of which are different. For example, it is acceptable to form the hole injection layer by a spin coating method and form the light-emitting layer by a nozzle printing method.

Note that in the coating methods, the organic EL layers are formed by applying ink containing an organic EL material to be each of the organic EL layers and, as solvents for ink to be used in forming them, for example, chlorine-based solvents such as chloroform, methylene chloride, and dichloroethane, ether-based solvents such as tetrahydrofuran, aromatic hydrocarbon-based solvents such as toluene and xylene, ketone-based solvents such as acetone and methyl ethyl ketone, ester-based solvents such as ethyl acetate, butyl acetate, and ethyl cellosolve acetate, and water are used.

Alternatively, as a method different from the coating methods, it is acceptable to form the organic EL layers by a vacuum deposition method, a sputtering method, and a lamination method.

Embodiments of the present invention have been described above, but the present invention is not limited to the above-described embodiments, and various modifications are possible.

### Industrial Applicability

With the light emitting device of the present invention, it is possible to fabricate organic EL elements having excellent light-emitting properties by partition walls having a simple structure.

### Reference Signs List

1... light emitting device, 2... partition wall, 2a... first partition wall member, 2b... second partition wall member, 3... support substrate, 4... organic EL element, 5... first electrode, 6, 7... organic EL layer, 8... second electrode, 9... ink, 11, 21, 31...light emitting device, 12... partition wall, 13... support substrate, 14... organic EL element, 15... first electrode, 16... hole injection layer, 17... light-emitting layer, 18... second electrode, 19... depressed portion, 20... extension portion

## Claims

1. A light emitting device comprising:
a support substrate;
partition walls provided on the support substrate and defining sections set on the support substrate; and
a plurality of organic electroluminescent (EL) elements provided on the sections defined by the partition walls, wherein
each of the organic EL elements is configured by laminating a first electrode, an organic EL layer, and a second electrode in this order on the support substrate,
at least part of the first electrode is arranged apart from the partition walls on the support substrate,
the organic EL layer has an extension portion extending from the first electrode to the partition walls, and
a surface of a member in contact with a bottom surface of the extension portion has a lyophilic property higher than that of a surface of each of the partition walls.

2. The light emitting device according to Claim 1, wherein the partition walls are formed so that a surface of each of the partition walls facing the first electrode becomes more separate from the first electrode as a distance from the support substrate increases.

3. The light emitting device according to Claim 1 or 2, further comprising an insulating film formed on a surface of the support substrate, wherein
the first electrode, the partition walls, and the extension portion are arranged in contact with the insulating film.

4. The light emitting device according to Claim 1 or 2, wherein the support substrate is made of a glass plate, and
the extension portion is arranged in contact with the glass plate.

5. The light emitting device according to any one of Claims 1 to 5, wherein the first electrode has a shape extending in a predetermined longitudinal direction on the support substrate, and
one end and the other end of the longitudinal direction of the first electrode are arranged apart from the partition walls.
